# EUROPÄISCHE PATENTSCHRIFT

(11) **EP 1 883 714 B1**
(45) Veröffentlichungstag und Bekanntmachung des Hinweises auf die Patenterteilung: **02.11.2011**
(21) Anmeldenummer: 06753597.1
(22) Anmeldetag: 13.05.2006
(51) Int. Cl.: C22C 9/10, C22C 9/06, F16C 33/12, F16C 33/14, B32B 15/20, C22F 1/08

(54) **GLEITLAGERVERBUNDWERKSTOFF, VERWENDUNG UND HERSTELLUNGSVERFAHREN**
SLIDE BEARING COMPOSITE MATERIAL, USE AND METHOD OF PRODUCTION
MATERIAU COMPOSITE POUR PALIERS LISSES, UTILISATION ET PROCEDE DE PRODUCTION CORRESPONDANTS

(30) Priorität: 13.05.2005 DE 102005023309
(43) Veröffentlichungstag der Anmeldung: 06.02.2008
(73) Patentinhaber: Federal-Mogul Wiesbaden GmbH, 65201 Wiesbaden (DE)
(72) Erfinder: WILHELM, Maik, 55270 Ober-Olm (DE); LEHMANN, Uwe, 55232 Alzey (DE); ANDLER, Gerd, 65307 Bad Schwalbach (DE); DAMOUR, Philippe, 60489 Frankfurt/Main (DE); GRAHAM, Neil, 65189 Wiesbaden (DE)
(74) Vertreter: Mehler Achler
(86) Internationale Anmeldenummer: PCT/EP2006/004517
(87) Internationale Veröffentlichungsnummer: WO 2006/120024

(56) Entgegenhaltungen:
- DE-A1- 1 558 474
- US-A1- 2003 099 853

## Beschreibung

Die Erfindung betrifft einen Gleitlagerverbundwerkstoff gemäß Anspruch 1. Ferner bezieht sich die Erfindung auf eine Verwendung und auf Herstellungsverfahren.

Aus der DE 44 15 629 C1 ist die Verwendung einer Kupfer-Nickel-Siliziumlegierung für die Herstellung von verschleißfesten Gegenständen mit Notlaufeigenschaften, wie beispielsweise Gießkolben von Druckgleßmaschinen bekannt. Die in der DE 44 15 629 C1 beschriebene Legierung besteht aus 1 - 4% Nickel, 0.1-1.5% Silizium und Rest Kupfer und wird als Massivwerkstoff eingesetzt.

Die US 2,137,282 beschreibt eine Legierung aus 0,1 - 30% Nickel, 0,05 - 3% Silizium und Rest Kupfer. Diese Legierung zeichnet sich nach entsprechender Wärmebehandlung durch große Härten und gute elektrische Leitfähigkeiten aus.

Die US 1,658,186 beschreibt eine Kupfer-Nickel-Siliziumlegierung, wobei ausführlich die als Hartteilchen wirkenden Silizide diskutiert werden. Verschiedene Wärmebehandlungsverfahren zur Einstellung der Härte werden angegeben.

Eine weitere Kupfer-Nickel-Siliziumlegierung findet sich in US 2,241,815, wobei der Nickelanteil bei 0,5 - 5% und der Siliziumanteil bei 0,1 - 2% liegt.

Auch in der DE 15 58 474 A1 ist eine Kupfer-Nickel-Siliziumlegierung mit 0.8 - 10% Nickel und 0,2 - 2% Silizium offenbart, der zum Erzielen einer hohen Formänderungsfähigkeit bei möglichst geringer vorgeschalteter Kaltverformung gezielt 0,01 - 0,5% Eisen und 0,05 - 0,5% Chrom zulegiert werden.

Die US 2,185,958 beschreibt Legierungen aus 1% Nickel, 3,5% Silizium und Rest Kupfer sowie aus 1,5% Silizium und 1% Nickel sowie Rest Kupfer.

Aus der DE 36 42 825 C1 ist ein Gleitlagerwerkstoff bestehend aus 4 bis 10% Nickel, 1 - 2% Aluminium, 1 - 3% Zinn und Rest Kupfer sowie übliche Verunreinigungen bekannt, der eine hohe Festigkeit und große Lebensdauer aufweisen soll. Aus diesem Gleitlagerwerkstoff werden Vollmaterialbuchsen hergestellt.

Die GB 2384007 beschreibt einen Gleitlagerverbundwerkstoff mit einem Stahlrücken, auf dem eine Sinterschicht aus einer Kupferlegierung aufgebracht ist, die eine Härte von max. 130 HV aufweist. Die Kupferlegierung weist 1 - 11 Gew.% Zinn, bis 0,2 Gew.% Phosphor, max. 10 Gew.% Nickel oder Silber, max. 25 Gew.% Blei und Wismut auf.

Gleitlagerschalen weisen in der Regel einen Stahlrücken auf, auf den ein Lagerwerkstoff und eine Gleitschicht aufgebracht sind. Der Stahlrücken weist die erforderliche Steifigkeit und Festigkeit auf, die den Presssitz in der Lageraufnahme garantieren. Nachteilig ist jedoch, dass die Dämpfungseigenschaften aus derartigem Verbundmaterial aufgebauter Lagerschalen und Lagerbuchsen für viele Anwendungsfälle nicht ausreichend sind. Insbesondere bei schmalen Lagerschalen in Kombination mit nicht ausreichend steifen Wellen kommt es häufig zu unerwünschten Kantenträgem und erhöhtem Verschleiß des Lagermetalls. Ursache hierfür ist das ungünstige Verhältnis aus E-Modul und Festigkeit des Stahlverbundwerkstoffes, der eine elastische Anpassung des Lagers bei kritischen Beanspruchungsfällen erschwert oder verhindert.

Aufgabe der Erfindung ist es daher, einen Gleitlagerverbundwerkstoff ohne Stahlrücken bereitzustellen, der bessere Dämpfungseigenschaften bei gleicher oder sogar höherer Festigkeit aufweist. Es ist auch Aufgabe, eine Verwendung und Herstellungsverfahren anzugeben.

Diese Aufgabe wird mit einem Gleitlagerverbundwerkstoff gemäß Patentanspruch 1 gelöst.

Es hat sich überraschend herausgestellt, dass auf einen Stahlrücken für die Gewährleistung des Presssitzes verzichtet werden kann, wenn eine Kupferlegierung mit Nickel-Siliziumanteilen in den beanspruchten Bereichen verwendet wird.

Die Vorteile dieser Legierungen bestehen darin, dass sie sich hinsichtlich ihrer Gefüge und damit ihrer mechanischen Eigenschaften in einem weiten Bereich einstellen lassen. Es ist daher möglich, die Festigkeit und die mechanischen Eigenschaften so einzustellen, dass die Kupferlegierung die Funktion des Stahlrückens übernimmt, der damit entfallen kann. Gleichzeitig besitzen diese Kupferlegierungen neben der erforderlichen Festigkeit auch hervorragende Dämpfungseigenschaften.

Die Herstellung des Geleitlagerelementes aus einem solchen Gleitlagerverbundwerkstoff wird aufgrund des Verzichts des Stahlrückens vereinfacht und somit kostengünstiger.

Als besonders vorteilhaft für den Einsatz als Gleitlager für hochbelastete Motoren hat sich bei diesen Legierungen das günstige Verhältnis aus E-Modul und einstellbarer Festigkeit erwiesen.

Ein weiterer Vorteil besteht darin, dass die thermischen Ausdehnungskoeffizienten der Kupferlegierungen in der Größenordnung der thermischen Ausdehnungskoeffizienten für Aluminium liegen, so dass Gleitlagerschalen aus dem erfindungsgemäßen Verbundmaterial vorzugsweise in Aluminiumgehäusen eingesetzt werden können. Bei hohen Temperaturen ist deshalb nach wie vor ein guter Presssitz gewährleistet.

Die Einstellung der Festigkeit der Kupferlegierung erfolgt vorzugsweise durch eine thermomechanische Behandlung, insbesondere durch Walzen und Glühen.

Das erfindungsgemäße Herstellungsverfahren von Bandmaterial für den Gleitlagerverbundwerkstoff sieht folgende Verfahrensschritte vor:
Herstellen von Bandmaterial aus einer Kupfer-Nickel-Silizium-Legierung mit anschließender thermomechanischer Behandlung mit folgenden Schritten:
   erstes Glühen des Bandmaterials bei Temperaturen größer 500°C für mindestens 3 Stunden, mindestens ein erstes Walzen des Bandmaterials, wobei ein Umformgrad von mindestens 20 % durchgeführt wird, mindestens ein zweites Glühen bei Temperaturen größer 500°C, und mindestens ein zweites Walzen des Bandmaterials, wobei ein Umformgrad von größer 30 % durchgeführt wird.
   Vorzugsweise wird das zweite Glühen kontinuierlich in einer Bandglühanlage mit einer Vorschubgeschwindigkeit des Bandes von mindestens 3 m/min, insbesondere von 3 - 5 m/min bei Temperaturen >500°C durchgeführt.

Mittels des zweiten Walzschrittes wird die Festigkeit des Bandmaterials eingestellt, wobei vorzugsweise Zugfestigkeitswerte von 550 bis 750 MPa realisiert werden.

Das Gefüge nach der thermo-mechanischen Behandlung zeichnet sich durch eine zeilenförmige Matrixstruktur aus, wobei innerhalb dieser Zeilenstruktur feine, gleichmäßig verteilte intermetallische Ausscheidungen auf NiSi-Basis vorliegen.

Die genannten Zugfestigkeitswerte liegen deutlich über denen vom Stahl des Stahlverbundwerkstoffes, der sich bereits bei geringerer Belastung plastisch verformen würde, was zu einer Spielzunahme des aus dem Verbundlagerwerkstoff hergestellten Gleitlagers und zu einem Verlust der Dämpfungseigenschaften führt. Der Vorteil der erfindungsgemäßen Kupferlegierungen besteht darin, dass die Streckgrenze soweit angehoben werden kann, dass bei hoher Lagerbelastung die elastischen Eigenschaften beibehalten werden können.

In der Regel ist die Dicke des Ausgangsbandmaterials sowie die Enddicke des Bandmaterials vorgegeben. Um unterschiedliche Festigkeitswerte erhalten zu können, wird daher vorzugsweise das erstmalige Walzen mit solchen Umformgraden durchgeführt, dass sich beim zweiten Walzen die gewünschten Festigkeitswerte einstellen. Dies bedeutet, dass beispielsweise zur Erreichung hoher Festigkeitswerte beim ersten Walzen nur eine geringe Dickenreduktion durchgeführt wird, während für niedrige Festigkeitswerte bereits beim ersten Walzen hohe Umformgrade erreicht werden.

Vom Bandmaterial werden zur Herstellung von Gleitlagerelementen nach dem Längsteilen des Bandes Platinen abgetrennt und die Platinen durch bekannte Umformschritte zu Gleitlagerelementen umgeformt. Der abschließende Prozess stellt das Gleitflächenbearbeiten und das Aufbringen der Gleitschicht dar.

Die Gleitschicht wird mittels galvanischer Abscheidung, PVD-Verfahren, insbesondere Sputtern, oder anderer in den Patentansprüchen genannten Verfahren, gegebenenfalls nach Aufbringen einer Zwischenschicht, aufgetragen. Gegebenenfalls wird auf die Gleitschicht noch eine Einlaufschicht aufgebracht.

Durch die Gleitschicht werden die tribologischen Eigenschaften des Verbundwerkstoffs eingestellt.

In der Kupfer-Nickel-Siliziumlegierung liegt der Nickelanteil bei 0,5 - 5 Gew.%, vorzugsweise bei 1,0 bis 3,0 Gew.%, insbesondere bei 1,5 bis 2,2 Gew.%, und der Siliziumanteil bei 0,2 - 2,5 Gew.%, vorzugsweise bei 0,4 bis 1,2 Gew.% oder bei 0,5 bis 1,5 Gew.%.

Die Kupfer-Nickel-Silizium-Legierung kann 0,05 - 2,0 Gew.% Mangan, vorzugsweise 0,15 -1,5 Gew.% aufweisen.

Es hat sich gezeigt, dass bei einem Gewichtsverhältnis von Nickel zu Silizium zwischen 2,5 und 5 (Nickel : Silizium = 2,5 bis 5) die tribologischen Eigenschaften verbessert werden können, insbesondere ein Fressen des Lagerwerkstoffes deutlich verringert werden kann. Bei diesen Gewichtsverhältnissen werden die für die guten tribologischen Eigenschaften verantwortlichen Nickel-Silizium-Verbindungen begünstigt und in ausreichendem Maße gebildet.

Die Kupferlegierungen können weitere Mikrolegierungselemente aufweisen. Vorzugsweise weist die Trägerschicht 0,05 - 0,4 Gew.%, vorzugsweise 0,075 bis 0,25 Gew.%, mindestens eines Mikrolegierungselementes auf. Als Mikrolegierungselemente kommen beispielsweise Chrom, Titan, Zirkon, Zink und Magnesium einzeln oder in Kombination in Frage.

Es ist weiterhin von Vorteil, wenn die Gleitschicht aus einer Galvanikschicht besteht. Galvanikschichten sind multifunktionale Werkstoffe, die sich unter anderem durch gute Einbettfähigkeit für Fremdpartikel, durch Einlaufeigenschaften bzw. Anpassung an den Gleitpartner, als Korrosionsschutz und durch gute Notlaufeigenschaften im Fall von Ölmangel auszeichnen. Insbesondere bei der Verwendung von niedrigviskosen Ölen sind Galvanikschichten von Vorteil, weil hierbei häufiger Mischreibungszustände auftreten können, bei denen die genannten Eigenschaften zum Tragen kommen.

Die Galvanikschicht besteht vorzugsweise aus Blei-Zinn-Kupfer-, Zinn-Kupfer-, Wismut- Kupferlegierung oder aus reinem Wismut.

In den Blei-Zinn-Kupfer-Legierungen liegt der Anteil von Zinn vorzugsweise bei 4 - 20 Gew.% und der von Kupfer bei 1 - 10 Gew.%. In den Wismut-Kupferlegierungen liegen die bevorzugten Anteile von Kupfer bei 1 - 20 Gew.%.

Die Gleitschicht kann auch mittels eines thermischen Beschichtungsverfahrens aufgebracht sein. Als thermische Beschichtungsverfahren kommen Plasmaspritzen, Hochgeschwindigkeitsflammspritzen und Kaltgasspritzen in Frage.

Ein weiteres bevorzugtes Verfahren ist das PVD-Verfahren und hier insbesondere das Sputtern. Sputter-Schichten bestehen vorzugsweise aus Aluminium-Zinnlegierungen, Aluminium-Zinn-Kupferlegierungen, Aluminium-Zinn-Nickel-Mangan-Legierungen, Aluminium-Zinn-Silizium-Legierungen oder Aluminium-Zinn-Silizium-Kupferlegierungen. Vorzugsweise beträgt in diesen Legierungen der Zinnanteil 8 - 40 Gew.%, der Kupferanteil 0,5 - 4,0 Gew.%, der Siliziumanteil 0,02 - 5,0 Gew.%, der Nickelanteil 0,02 - 2,0 Gew.% und der Mangananteil 0,02 - 2,5 Gew.%.

Gemäß einer weiteren Ausführungsform kann die Gleitschicht aus einer Kunststoffschicht bestehen. Kunststoffschichten werden vorzugsweise mittels eines Lackier- oder Druckverfahrens, wie z. B. Sieb- oder Kissendruck, durch Tauchen oder Spritzen aufgetragen.

Die zu beschichtende Oberfläche muss hierzu geeignet vorbereitet werden durch Entfetten, chemisches oder physikalisches Aktivieren und/oder mechanisches Anrauhen, beispielsweise durch Sandstrahlen oder Schleifen.

Die Matrix der Kunststoffschichten besteht vorzugsweise aus hochtemperaturbeständigen Harzen wie PAI. Außerdem können in die Matrix Zusätze wie MoS₂, Bornitrid, Graphit oder PTFE eingelagert sein. Die Anteile der Zusätze einzeln oder in Kombination liegen vorzugsweise zwischen 5 und 50 Vol.%.

Um die Bindung zu verbessern, ist vorzugsweise zwischen der Trägerschicht und der Gleitschicht mindestens eine Zwischenschicht angeordnet. Diese Zwischenschicht kann ebenfalls eine Galvanikschicht sein, auch dann, wenn die Gleitschicht mittels eines Sputter-Verfahrens aufgebracht wird.

Die Zwischenschicht, die galvanisch aufgebracht wird, kann Nickel oder Silber aufweisen oder aus diesen Elementen bestehen. Es ist auch möglich zwei Zwischenschichten aus Nickel und Zinn-Nickel aufzubringen.

Anstelle von galvanisch aufgebrachten Zwischenschichten können auch Sputter-Zwischenschichten vorgesehen sein. In diesem Fall sind Nickellegierungsschichten, z. B. aus NiCu30, reine Nickelschichten, Nickel-Chromschichten, die vorzugsweise 15 - 25 % Chrom enthalten, Zinkschichten, Zinklegierungsschichten, Chrom- und Kupferschichten, Nickel-Chrom-Legierungsschichten, Nickel-Kupfer-Legierungsschichten, Kupfer-Legierungsschichten oder Chrom-NickelLegierungsschichten bevorzugt.

Die Dicke der Trägerschicht liegt vorzugsweise bei 1,2 - 4 mm, vorzugsweise bei 1,3 - 3,5 mm, insbesondere bei 1,4 - 3,0 mm.

Für die Dicke der Zwischenschicht sind 1 - 12 µm, vorzugsweise 0,5 - 7,0 µm, insbesondere 1,0 - 4,0 µm, bevorzugt und für die Dicke der Gleitschicht 4 - 30 µm, vorzugsweise 8 - 20 µm, insbesondere 10 - 16 µm.

Die Dicke der Einlaufschicht liegt bei 0,2 -12 µm, vorzugsweise bei 0,2 bis 6 m, insbesondere bei 0,2 bis 3 µm.

Bevorzugte Verwendungen des Gleitlagerverbundwerkstoffes sind solche für Gleitlagerschalen.

Beispielhafte Kupferlegierungen sind:

**Tabelle 1 (Angaben in Gew.%)**

| Beispiel | 1 | 2 | 3 | 4 | 5 |
|---|---|---|---|---|---|
| Ni | 1,9 | 1,5 | 0.8 | 3,8 | 2,8 |
| Si | 0,6 | 0,5 | 0,25 | 1,2 | 0,8 |
| Mn | 0,15 | 0,05 | 0,05 | 0,1 | 0,05 |
| Pb | <0,1 | <0,1 | <0,1 | <0,1 | <0,1 |
| Cr | | 0,15 | | | 0,15 |
| Ti | | | | 0,15 | |
| Zr | | | 0,2 | | 0,15 |
| Cu | Rest | Rest | Rest | Rest | Rest |

Ein beispielhaftes Verfahren sieht folgende Verfahrensschritte vor:
- Stranggießen einer Kupferlegierung, beispielsweise Doppelstranggießen, mit einer Breite von 300 mm und einer Dicke von 10 mm zur Herstellung von Bandmaterial
- Beidseitiges Fräsen und anschließendes Aufwickeln des Bandmaterials.

Es folgt dann ein erster Glühschritt in einem Haubenofen bei 650°C über 4 Stunden. Im Anschluss daran wird ein erstes Walzen mit 3 Walzschritten durchgeführt. In allen drei Walzschritten wird eine Umformung von 31 % vorgenommen, wobei im ersten Walzschritt die Dicke auf 5,5 mm, im zweiten Walzschritt auf 3,8 mm und im dritten Walzschritt auf 2,6 mm durchgeführt wird.

In einer Bandglühanlage wird anschließend das Band bei 650 °C mit einer Vorlaufgeschwindigkeit von 4m/min geglüht. Hieran schließt sich ein zweites Walzen mit einem Walzschritt an mit einem Umformgrad von 40 %, wobei die Dicke auf 1,56 mm reduziert wird. Anschließend erfolgt ein Längsteilen mit Abmessungen von 95 mm Breite x 1,56 mm Dicke.

Beispiele für Galvanikgleitschichten sind in der Tabelle 2 zusammengestellt.

**Tabelle 2 (Angaben in Gew.%)**

| Beispiel | 1 | 2 | 3 | 4 | 5 |
|---|---|---|---|---|---|
| Blei | 88 | 78 | | | |
| Zinn | 10 | 14 | 94 | | |
| Wismut | | | | 100 | 95 |
| Kupfer | 2 | 8 | 6 | | 5 |

Eine bevorzugte galvanische Gleitschicht weist eine Zinnmatrix auf, in die Zinn-Kupfer-Partikel eingelagert sind, die aus 39 - 55 Gew.% Kupfer und Rest Zinn bestehen. Der Partikeldurchmesser liegt vorzugsweise bei 0,5 µm bis 3 µm. Diese galvanische Schicht wird vorzugsweise auf zwei Zwischenschichten aufgebracht, wobei die erste Zwischenschicht aus Ni und die darüber liegende zweite Zwischenschicht aus Nickel und Zinn besteht. Der Ni-Anteil der zweiten Zwischenschicht liegt bei 30 - 40 Gew.% Ni. Die erste Zwischenschicht hat eine Dicke von 1 bis 4 µm und die zweite Zwischenschicht von 2 bis 7 µm.

Beispiele für Sputter-Schichten sind in der Tabelle 3 zusammengefasst.

**Tabelle 3 (Angaben in Gew.%)**

| Beispiel | 1 | 2 | 3 | 4 | 5 |
|---|---|---|---|---|---|
| Al | Rest | Rest | Rest | Rest | Rest |
| Sn | 22 | 35 | 25 | 10 | 20 |
| Cu | 0,7 | 1,2 | 0,7 | 0,5 | 0,5 |
| Si | | | 2,5 | | 1,5 |
| Mn | | | | 1,5 | |
| Ni | | | | 0,7 | 0,7 |

Beispiele für Kunststoffgleitschichten sind in der Tabelle 4 zusammengefasst.

**Tabelle 4 (Angaben in Vol.%)**

| Beispiel | 1 | 2 | 3 | 4 | 5 |
|---|---|---|---|---|---|
| PAI | 70 | 80 | 70 | 75 | 65 |
| MoS2 | 30 | | | | 20 |
| BN | | 20 | | | |
| Graphit | | | 30 | | |
| PTFE | | | | 25 | 15 |

Alle genannten Gleitschichten können mit Trägerschichten aus den Kupferlegierungen kombiniert werden.

Als Einlaufschichten auf diesen Schichtkombinationen können reine Zinn- oder Indium-Schichten, sowie alle genannten Galvanik- und Kunststoffschichten eingesetzt werden, wobei die Einlaufschicht vorzugsweise weicher als die eingesetzte Gleitschicht zu wählen ist.

## Patentansprüche

1. Gleitlagerverbundwerkstoff mit einer Trägerschicht aus einer Kupferlegierung aufweisend 0,5 - 5 Gew.% Nickel, 0,2 - 2,5 Gew.% Silizium, ≤0,1 Gew.% Blei, wahlweise 0,05 - 2 Gew.% Mangan, wahlweise 0,05 - 0,4 Gew.% mindestens eines Mikrolegierungselements und Rest Kupfer und mit einer auf der Trägerschicht aufgebrachten Gleitschicht.

2. Gleitlagerverbundwerkstoff nach Anspruch 1, **dadurch gekennzeichnet, dass** die Kupferlegierung 0,05 - 2 Gew.% Mangan aufweist.

3. Gleitlagerverbundwerkstoff nach Anspruch 1 oder 2, **dadurch gekennzeichnet, dass** das Gewichtsverhältnis von Nickel zu Silizium zwischen 2,5 und 5 liegt.

4. Gleitlagerverbundwerkstoff nach einem der Ansprüche 1 bis 3, **dadurch gekennzeichnet, dass** die Trägerschicht 0,05 - 0,4 Gew.% mindestens eines Mikrolegierungselements aufweist.

5. Gleitlagerverbundwerkstoff nach Anspruch 4, **dadurch gekennzeichnet, dass** die Mikrolegierungselemente Chrom, Titan, Zirkon, Zink und/oder Magnesium sind.

6. Gleitlagerverbundwerkstoff nach einem der Ansprüche 1 bis 5, **dadurch gekennzeichnet, dass** die Gleitschicht aus einer Galvanikschicht besteht.

7. Gleitlagerverbundwerkstoff nach Anspruch 6, **dadurch gekennzeichnet, dass** die Galvanikschicht aus Blei-Zinn-Kupfer-Legierung, Zinn-Kupfer-Legierung, Wismut-Kupfer-Legierung oder aus Wismut besteht.

8. Gleitlagerverbundwerkstoff nach Anspruch 7, **dadurch gekennzeichnet, dass** in den Blei-Zinn-Kupfer-Legierungen der Anteil von Zinn 4 - 20 Gew.% und der Anteil von Kupfer 1 -10 Gew.% beträgt.

9. Gleitlagerverbundwerkstoff nach Anspruch 8, **dadurch gekennzeichnet, dass** in den Wismut-Kupfer-Legierungen der Kupfer-Anteil 1 - 20 Gew.% und in den Zinn-Kupfer-Legierungen der Kupfer-Anteil 2 - 20 Gew.% beträgt.

10. Gleitlagerverbundwerkstoff nach einem der Ansprüche 1 bis 5, **dadurch gekennzeichnet, dass** die Gleitschicht aus einer mittels eines thermischen Beschichtungsverfahrens aufgebrachten Schicht besteht.

11. Gleitlagerverbundwerkstoff nach einem der Ansprüche 1 bis 5, **dadurch gekennzeichnet, dass** die Gleitschicht aus einer Kunststoffschicht besteht.

12. Gleitlagerverbundwerkstoff nach Anspruch 11, **dadurch gekennzeichnet, dass** die Matrix der Kunststoffgleitschicht aus hochtemperaturbeständigem Harz wie PAI besteht.

13. Gleitlagerverbundwerkstoff nach Anspruch 11 oder 12, **dadurch gekennzeichnet, dass** die Kunststoffgleitschicht als Füllstoffe MoS₂, Bornitrid, PTFE und/oder Graphit aufweist.

14. Gleitlagerverbundwerkstoff nach Anspruch 13, **dadurch gekennzeichnet, dass** die Anteile der Füllstoffe einzeln oder in Kombination bei 5 - 50 Vol.% liegen.

15. Gleitlagerverbundwerkstoff nach einem der Ansprüche 1 bis 14, **dadurch gekennzeichnet, dass** zwischen der Trägerschicht und der Gleitschicht mindestens eine Zwischenschicht angeordnet ist.

16. Gleitlagerverbundwerkstoff nach Anspruch 15, **dadurch gekennzeichnet, dass** die Zwischenschicht eine Galvanikschicht ist.

17. Gleitlagerverbundwerkstoff nach Anspruch 16, **dadurch gekennzeichnet, dass** die Zwischenschicht Nickel oder Silber aufweist.

18. Gleitlagerverbundwerkstoff nach Anspruch 16, **dadurch gekennzeichnet, dass** zwei Zwischenschichten aus Nickel und Zinn-Nickel vorgesehen sind.

19. Gleitlagerverbundwerkstoff nach Anspruch 15, **dadurch gekennzeichnet, dass** die Zwischenschicht eine Sputter-Schicht ist.

20. Gleitlagerverbundwerkstoff nach einem der Ansprüche 15 bis 19, **dadurch gekennzeichnet, dass** die Zwischenschicht aus einer Nickellegierung, einer Nickel-Chrom-Legierung, Nickel-Kupfer-Legierung, Zinklegierung, Zink, Chrom, Kupfer, Kupfer-Legierung, Nickel, Chrom-Nickel-Legierung oder Nickel-Chrom besteht.

21. Gleitlagerverbundwerkstoff nach einem der Ansprüche 1 bis 5 in Verbindung mit einem der Ansprüche 15 bis 20, **dadurch gekennzeichnet, dass** die Gleitschicht aus einer mittels PVD-Verfahren aufgebrachten Schicht besteht.

22. Gleitlagerverbundwerkstoff nach Anspruch 21, **dadurch gekennzeichnet, dass** die Gleitschicht aus einer Sputter-Schicht besteht.

23. Gleitlagerverbundwerkstoff nach Anspruch 22, **dadurch gekennzeichnet, dass** die Sputter-Schicht aus einer Aluminium-Zinn-Legierung, Aluminium-Zinn-Silizium-Legierung, Aluminium-Zinn-Kupfer-Legierung, einer Aluminium-Zinn-Silizium-Kupfer-Legierung oder einer Aluminium-Zinn-Nickel-Mangan-Legierung besteht.

24. Gleitlagerverbundwerkstoff nach Anspruch 23, **dadurch gekennzeichnet, dass** in den Legierungen der Zinnanteil 8 - 40 Gew.%, der Kupferanteil 0,5 - 4,0 Gew.%, der Silizium anteil 0,02 - 5,0 Gew.%, der Nickelanteil 0,02 - 2,0 Gew.% und der Mangananteil 0,02 - 2,5 Gew.% beträgt.

25. Gleitlagerverbundwerkstoff nach Anspruch 22, **dadurch gekennzeichnet, dass** die Zwischenschicht aus einer Galvanikschicht und die Gleitschicht aus einer Sputter-Schicht besteht.

26. Gleitlagerverbundwerkstoff nach einem der Ansprüche 1 bis 25, **dadurch gekennzeichnet, dass** auf der Gleitschicht eine Einlaufschicht vorgesehen ist.

27. Gleitlagerverbundwerkstoff nach Anspruch 26, **dadurch gekennzeichnet, dass** die Einlaufschicht als Zinn-, Blei-, Kupfer-oder Indium- oder als Kunststoffschicht ausgeführt ist.

28. Gleitlagerverbundwerkstoff nach einem der Ansprüche 1 bis 27, **dadurch gekennzeichnet, dass** die Dicke der Trägerschicht 1,2 - 4 mm beträgt.

29. Gleitlagerverbundwerkstoff einem der Ansprüche 1 bis 28,
**dadurch gekennzeichnet, dass** die Dicke der Zwischenschicht 1 -12 µm beträgt.

30. Gleitlagerverbundwerkstoff nach einem der Ansprüche 1 bis 29, **dadurch gekennzeichnet, dass** die Dicke der Gleitschicht 4 - 30 µm beträgt.

31. Gleitlagerverbundwerkstoff nach einem der Ansprüche 26 bis 30, **dadurch gekennzeichnet, dass** die Dicke der Einlaufschicht 0,2 bis 12 µm beträgt.

32. Verwendung eines Gleitlagerverbundwerkstoffes nach Anspruch 1 für Gleitlagerschalen.

33. Verfahren zur Herstellung von Bandmaterial, insbesondere für Gleitlagerelemente, wie Gleitlagerschalen, mit folgenden Verfahrensschritten:
- Herstellen von Bandmaterial aus einer Kupferlegierung gemäß Anspruch 1,
- thermo-mechanische Behandlung des Bandmaterials mit folgenden Schritten:
- mindestens ein erstes Glühen des Bandmaterials bei einer Temperatur größer 500°C für mindestens 3 Stunden
- mindestens ein erstes Walzen des Bandmaterials, wobei ein Umformgrad von mindestens 20 % durchgeführt wird.
- mindestens ein zweites Glühen bei einer Temperatur größer 500°C und
- mindestens ein zweites Walzen des Bandmaterials, wobei ein Umformgrad von größer 30 % durchgeführt wird.

34. Verfahren nach Anspruch 33, **dadurch gekennzeichnet, dass** das zweite Glühen kontinuierlich in einer Bandglühanlage mit einer Vorschubgeschwindigkeit von mindestens 3 m/min bei Temperaturen >500°C durchgeführt wird.

35. Verfahren zur Herstellung von Gleitlagerelementen, insbesondere von Gleitlagerschalen, **dadurch gekennzeichnet,**
**dass** ein Bandmaterial nach Anspruch 33 oder 34 hergestellt wird,
**dass** vom Bandmaterial Platinen abgetrennt werden,
**dass** diese Platinen zu Gleitlagerelementen umgeformt werden und
**dass** eine Gleitschicht aufgebracht wird.

36. Verfahren nach Anspruch 35, **dadurch gekennzeichnet, dass** vor dem Aufbringen der Gleitschicht mindestens eine Zwischenschicht aufgebracht wird.

37. Verfahren nach einem der Ansprüche 35 oder 36, **dadurch gekennzeichnet, dass** nach dem Aufbringen der Gleitschicht eine Einlaufschicht aufgebracht wird.

## Claims

1. Slide bearing composite material having a carrier layer composed of a copper alloy having 0.5 - 5% by weight of nickel, 0.2 - 2.5% by weight of silicon, ≤0.1% by weight of lead, optionally 0.05 - 2% by weight of manganese, optionally 0.05 - 0.4% by weight of at least one microalloying element and remainder copper and having a sliding layer applied to the carrier layer.

2. Slide bearing composite material according to claim 1, **characterised in that** the copper alloy has 0.05 - 2% by weight of manganese.

3. Slide bearing composite material according to claim 1 or 2, **characterised in that** the ratio by weight of nickel to silicon is from 2.5 to 5.

4. Slide bearing composite material according to any one of claims 1 to 3, **characterised in that** the carrier layer has 0.05 - 0.4% by weight of at least one microalloying element.

5. Slide bearing composite material according to claim 4, **characterised in that** the microalloying elements are chromium, titanium, zirconium, zinc and/or magnesium.

6. Slide bearing composite material according to any one of claims 1 to 5, **characterised in that** the sliding layer comprises an electroplated layer.

7. Slide bearing composite material according to claim 6, **characterised in that** the electroplated layer is composed of lead-tin-copper alloy, tin-copper alloy, bismuth-copper alloy or of bismuth.

8. Slide bearing composite material according to claim 7, **characterised in that**, in the lead-tin-copper alloys, the proportion of tin is 4 - 20% by weight and the proportion of copper is 1 - 10% by weight.

9. Slide bearing composite material according to claim 8, **characterised in that**, in the bismuth-copper alloys, the proportion of copper is 1 - 20% by weight and, in the tin-copper alloys, the proportion of copper is 2 - 20% by weight.

10. Slide bearing composite material according to any one of claims 1 to 5, **characterised in that** the sliding layer comprises a layer applied by means of a thermal coating process.

11. Slide bearing composite material according to any one of claims 1 to 5, **characterised in that** the sliding layer comprises a plastics layer.

12. Slide bearing composite material according to claim 11, **characterised in that** the matrix of the plastics sliding layer is composed of high-temperature-resistant resin such as PAI.

13. Slide bearing composite material according to claim 11 or 12, **characterised in that** the plastics sliding layer has MoS₂, boron nitride, PTFE and/or graphite as fillers.

14. Slide bearing composite material according to claim 13, **characterised in that** the proportions of the fillers individually or in combination are 5 - 50% by volume.

15. Slide bearing composite material according to any one of claims 1 to 14, **characterised in that** at least one intermediate layer is arranged between the carrier layer and the sliding layer.

16. Slide bearing composite material according to claim 15, **characterised in that** the intermediate layer is an electroplated layer.

17. Slide bearing composite material according to claim 16, **characterised in that** the intermediate layer has nickel or silver.

18. Slide bearing composite material according to claim 16, **characterised in that** two intermediate layers of nickel and tin-nickel are provided.

19. Slide bearing composite material according to claim 15, **characterised in that** the intermediate layer is a sputtered layer.

20. Slide bearing composite material according to any one of claims 15 to 19, **characterised in that** the intermediate layer is composed of a nickel alloy, a nickel-chromium alloy, nickel-copper alloy, zinc alloy, zinc, chromium, copper, copper alloy, nickel, chromium-nickel alloy or nickel-chromium.

21. Slide bearing composite material according to any one of claims 1 to 5 in combination with any one of claims 15 to 20, **characterised in that** the sliding layer comprises a layer applied by PVD processes.

22. Slide bearing composite material according to claim 21, **characterised in that** the sliding layer comprises a sputtered layer.

23. Slide bearing composite material according to claim 22, **characterised in that** the sputtered layer is composed of an aluminium-tin alloy, aluminium-tin-silicon alloy, aluminium-tin-copper alloy, an aluminium-tin-silicon-copper alloy or an aluminium-tin-nickel-manganese alloy.

24. Slide bearing composite material according to claim 23, **characterised in that**, in the alloys, the proportion of tin is 8 - 40% by weight, the proportion of copper 0.5 - 4.0% by weight, the proportion of silicon 0.02 - 5.0% by weight, the proportion of nickel 0.02 - 2.0% by weight and the proportion of manganese 0.02 - 2.5% by weight.

25. Slide bearing composite material according to claim 22, **characterised in that** the intermediate layer comprises an electroplated layer and the sliding layer comprises a sputtered layer.

26. Slide bearing composite material according to any one of claims 1 to 25, **characterised in that** a running-in layer is provided on the sliding layer.

27. Slide bearing composite material according to claim 26, **characterised in that** the running-in layer is in the form of a tin, lead, copper or indium layer or in the form of a plastics layer.

28. Slide bearing composite material according to any one of claims 1 to 27, **characterised in that** the thickness of the carrier layer is 1.2 - 4 mm.

29. Slide bearing composite material according to any one of claims 1 to 28, **characterised in that** the thickness of the intermediate layer is 1 - 12 µm.

30. Slide bearing composite material according to any one of claims 1 to 29, **characterised in that** the thickness of the sliding layer is 4 - 30 µm.

31. Slide bearing composite material according to any one of claims 26 to 30, **characterised in that** the thickness of the running-in layer is from 0.2 to 12 µm.

32. Use of a slide bearing composite material according to claim 1 for slide bearing shells.

33. Method for the manufacture of strip material, especially for slide bearing elements, such as slide bearing shells, having the following method steps:
- manufacture of strip material from a copper alloy according to claim 1,
- thermo-mechanical treatment of the strip material with the following steps:
- at least one first annealing of the strip material at a temperature greater than 500°C for at least 3 hours,
- at least one first rolling of the strip material, a degree of deformation of at least 20% being carried out,
- at least one second annealing at a temperature greater than 500°C and
- at least one second rolling of the strip material, a
degree of deformation greater than 30% being carried out.

34. Method according to claim 33, **characterised in that** the second annealing is carried out continuously in a strip-annealing installation at a rate of advance of at least 3 m/min at temperatures >500°C.

35. Method for the manufacture of slide bearing elements, especially slide bearing shells, **characterised in that**
a strip material is manufactured according to claim 33 or 34,
bars are cut from the strip material,
those bars are deformed to form slide bearing elements and a sliding layer is applied.

36. Method according to claim 35, **characterised in that** at least one intermediate layer is applied before the application of the sliding layer.

37. Method according to either claim 35 or claim 36, **characterised in that** a running-in layer is applied after the application of the sliding layer.

## Revendications

1. Matériau composite pour paliers lisses avec une couche de support en alliage de cuivre, présentant 0,5 - 5 % en poids de nickel, 0,2 - 2,5 % en poids de silicium, < 0,1 % en poids de plomb, au choix 0,05 - 2 % de manganèse, au choix 0,05 - 0,4 % en poids d'au moins un élément de microalliage et de cuivre résiduel et avec une couche de glissement appliquée sur la couche de support.

2. Matériau composite pour paliers lisses selon la revendication 1, **caractérisé en ce que** l'alliage de cuivre présente 0,05 - 2 % en poids de manganèse.

3. Matériau composite pour paliers lisses selon la revendication 1 ou 2, **caractérisé en ce que** le rapport de poids entre nickel et silicium est compris entre 2,5 et 5.

4. Matériau composite pour paliers lisses selon une des revendications 1 à 3, **caractérisé en ce que** la couche de support présente 0,05 - 0,4 % en poids d'au moins un élément de microalliage.

5. Matériau composite pour paliers lisses selon la revendication 4, **caractérisé en ce que** les éléments de microalliage sont du chrome, du titane, du zirconium, du zinc et/ou du magnésium.

6. Matériau composite pour paliers lisses selon une des revendications 1 à 5, **caractérisé en ce que** la couche de glissement est composée d'une couche galvanique.

7. Matériau composite pour paliers lisses selon la revendication 6, **caractérisé en ce que** la couche galvanique est composée d'un alliage plomb-étain-cuivre, d'un alliage étain-cuivre, d'un alliage bismuth-cuivre ou de bismuth.

8. Matériau composite pour paliers lisses selon la revendication 7, **caractérisé en ce que** dans les alliages plomb-étain-cuivre, la part d'étain s'élève à 4 - 20 % en poids et la part de cuivre à 1 - 10 % en poids.

9. Matériau composite pour paliers lisses selon la revendication 8, **caractérisé en ce que** dans les alliages bismuth-cuivre, la part de cuivre s'élève à 1 - 20 % en poids et dans les alliages étain-cuivre, la part de cuivre s'élève à 2 - 20 % en poids.

10. Matériau composite pour paliers lisses selon une des revendications 1 à 5, **caractérisé en ce que** la couche de glissement est composée d'une couche appliquée au moyen d'un procédé de revêtement thermique.

11. Matériau composite pour paliers lisses selon une des revendications 1 à 5, **caractérisé en ce que** la couche de glissement est composée d'une couche en matière plastique.

12. Matériau composite pour paliers lisses selon la revendication 11, **caractérisé en ce que** la matrice de la couche de glissement en matière plastique est composée d'une résine résistante aux hautes températures telle que PAI.

13. Matériau composite pour paliers lisses selon la revendication 11 ou 12, **caractérisé en ce que** la couche de glissement en matière plastique présente du MoS₂, du nitrure de bore, du PTFE et/ou du graphite comme matières de charge.

14. Matériau composite pour paliers lisses selon la revendication 13, **caractérisé en ce que** les parts de matières de charge sont comprises individuellement ou en combinaison entre 5 et 50 % en volume.

15. Matériau composite pour paliers lisses selon une des revendications 1 à 14, **caractérisé en ce qu'**au moins une couche intermédiaire est disposée entre la couche de support et la couche de glissement.

16. Matériau composite pour paliers lisses selon la revendication 15, **caractérisé en ce que** la couche intermédiaire est une couche galvanique.

17. Matériau composite pour paliers lisses selon la revendication 16, **caractérisé en ce que** la couche intermédiaire présente du nickel ou de l'argent.

18. Matériau composite pour paliers lisses selon la revendication 16, **caractérisé en ce que** deux couches intermédiaires en nickel et étain-nickel sont prévues.

19. Matériau composite pour paliers lisses selon la revendication 15, **caractérisé en ce que** la couche intermédiaire est une couche appliquée par pulvérisation.

20. Matériau composite pour paliers lisses selon une des revendications 15 à 19, **caractérisé en ce que** la couche intermédiaire est composée d'un alliage de nickel, d'un alliage nickel-chrome, d'un alliage nickel-cuivre, d'un alliage de zinc, de zinc, de chrome, de cuivre, d'un alliage de cuivre, de nickel, d'un alliage chrome-nickel ou de nickel-chrome.

21. Matériau composite pour paliers lisses selon une des revendications 1 à 5 en liaison avec une des revendications 15 à 20, **caractérisé en ce que** la couche de glissement est composée d'une couche appliquée au moyen d'un procédé PVD.

22. Matériau composite pour paliers lisses selon la revendication 21, **caractérisé en ce que** la couche de glissement est composée d'une couche appliquée par pulvérisation.

23. Matériau composite pour paliers lisses selon la revendication 22, **caractérisé en ce que** la couche appliquée par pulvérisation est composée d'un alliage aluminium-étain, d'un alliage aluminium-étain-silicium, d'un alliage aluminium-étain-cuivre, d'un alliage aluminium-étain-silicium-cuivre ou d'un alliage aluminium-étain-nickel-manganèse.

24. Matériau composite pour paliers lisses selon la revendication 23, **caractérisé en ce que** dans les alliages, la part d'étain s'élève à 8 - 40 % en poids, la part de cuivre à 0,5 - 4,0 % en poids, la part de silicium à 0,02 - 5,0 % en poids, la part de nickel à 0,02 - 2,0 % en poids et la part de manganèse à 0,02 - 2,5 % en poids.

25. Matériau composite pour paliers lisses selon la revendication 22, **caractérisé en ce que** la couche intermédiaire est composée d'une couche galvanique et la couche de glissement d'une couche appliquée par pulvérisation.

26. Matériau composite pour paliers lisses selon une des revendications 1 à 25, **caractérisé en ce qu'**une couche de rodage est prévue sur la couche de glissement.

27. Matériau composite pour paliers lisses selon la revendication 26, **caractérisé en ce que** la couche de rodage est réalisée sous la forme d'une couche en étain, plomb, cuivre ou indium ou sous la forme d'une couche en matière plastique.

28. Matériau composite pour paliers lisses selon une des revendications 1 à 27, **caractérisé en ce que** l'épaisseur de la couche de support est comprise entre 1,2 et 4 mm.

29. Matériau composite pour paliers lisses selon une des revendications 1 à 28, **caractérisé en ce que** l'épaisseur de la couche intermédiaire est comprise entre 1 et 12 µm.

30. Matériau composite pour paliers lisses selon une des revendications 1 à 29, **caractérisé en ce que** l'épaisseur de la couche de glissement est comprise entre 4 et 30 µm.

31. Matériau composite pour paliers lisses selon une des revendications 26 à 30, **caractérisé en ce que** l'épaisseur de la couche de rodage est comprise entre 0,2 et 12 µm.

32. Utilisation d'un matériau composite pour paliers lisses selon la revendication 1 pour des coquilles de paliers lisses.

33. Procédé de fabrication d'un matériau en bande, en particulier pour des éléments de paliers lisses tels que coquilles de paliers lisses, présentant les étapes suivantes :
- fabrication d'un matériau en bande à partir d'un alliage de cuivre selon la revendication 1,
- traitement thermomécanique du matériau en bande présentant les étapes suivantes :
- au moins un premier recuit du matériau en bande à une température supérieure à 500 °C pendant au moins 3 heures,
- au moins un premier laminage du matériau en bande, un degré de déformation d'au moins 20 % étant réalisé,
- au moins un deuxième recuit à une température supérieure à 500 °C et
- au moins un deuxième laminage du matériau en bande, un degré de déformation d'au moins 30 % étant réalisé.

34. Procédé selon la revendication 33, **caractérisé en ce que** le deuxième recuit est réalisé en continu dans une installation de recuit de bande à une vitesse d'avance d'au moins 3 mm/min à des températures > 500 °C.

35. Procédé de fabrication d'éléments de paliers lisses, en particulier de coquilles de paliers lisses, **caractérisé en ce**
**qu'**un matériau en bande selon la revendication 33 ou 34 est fabriqué,
**que** des platines sont séparées du matériau en bande,
**que** ces platines sont transformées en éléments de paliers lisses et
**qu'**une couche de glissement est appliquée.

36. Procédé selon la revendication 35, **caractérisé en ce qu'**au moins une couche intermédiaire est appliquée avant l'application de la couche de glissement.

37. Procédé selon une des revendications 35 ou 36, **caractérisé en ce qu'**une couche de rodage est appliquée après l'application de la couche de glissement.
